## Europäisches Patentamt

(19) **European Patent Office**

**Office européen des brevets**

(11) Veröffentlichungsnummer: **0 175 253**

**B1**

(12) # EUROPÄISCHE PATENTSCHRIFT

(45) Veröffentlichungstag der Patentschrift:
**12.07.89**

(51) Int. Cl.⁴: **H 05 K 3/10**, G 03 C 5/00, C 23 C 18/18

(21) Anmeldenummer: **85111363.9**

(22) Anmeldetag: **09.09.85**

(54) **Verfahren zur partiellen Aktivierung von Substratoberflächen.**

(30) Priorität: **19.09.84 DE 3434431**
**02.02.85 DE 3503566**

(43) Veröffentlichungstag der Anmeldung:
**26.03.86 Patentblatt 86/13**

(45) Bekanntmachung des Hinweises auf die Patenterteilung:
**12.07.89 Patentblatt 89/28**

(84) Benannte Vertragsstaaten:
**BE CH DE FR GB IT LI NL SE**

(56) Entgegenhaltungen:
**GB-A-1 243 251**
**US-A-3 223 525**
**US-A-3 904 783**

**REVIEW OF THE ELECTRICAL COMMUNICATION LABORATORIES, Band 25, Nr. 5-6, Mai-Juni 1977, Seiten 570-579, Tokyo, JA, JP; A. IWASAWA et al.: "Printed circuit fabricating method using photochemical reaction"**

(73) Patentinhaber: **BAYER AG, D-5090 Leverkusen 1 Bayerwerk (DE)**

(72) Erfinder: **Giesecke, Henning, Dr., Walter- Flex- Strasse 18, D-5090 Leverkusen (DE)**
Erfinder: **Wolf, Gerhard Dieter, Dr., Wilhelm- Busch- Strasse 29, D-4047 Dormagen 5 (DE)**
Erfinder: **von Gizycki, Ulrich, Dr., Wiembachallee 24, D-5090 Leverkusen 3 (DE)**
Erfinder: **Matejek, Reinhart, Dr., Hegelstrasse 25, D-5090 Leverkusen (DE)**

## Beschreibung

Die Herstellung von Leiterplatten für die Elektronik erfolgt zum überwiegenden Teil nach der sogenannten Subtraktiv-Technik (G. Hermann: Leiterplatten-Herstellung und Verarbeitung, Eugen G. Leuze Verlag, Saulgau/Württ. 1978). Erst seit einigen Jahren bahnt sich die Einführung der Semiadditiv-Technik an, die mit weniger Verfahrensschritten als die Subtraktiv-Technik auskommt und weniger Kupferabfälle produziert, dafür aber nach wie vor auf Maskier- und Ätzprozesse angewiesen ist. Noch ein facher ist die Volladditivtechnik, insbesondere eine lackfreie Fotoadditiv-Variante, da diese Technologie nur etwa die Hälfte der Verfahrensschritte der Subtraktiv-Technik benötigt und das am meisten Rohstoff sparende und umweltfreundliche Verfahren darstellt. Bisher konnten aber die technischen Probleme einer lackfreien Volladditivtechnik nicht hinreichend gelöst werden. Der Verfahrensablauf dieser Technik läßt sich im wesentlichen in 3 Abschnitte unterteilen.

1. Vorbehandlung des Basismaterials (d.h. Zuschnitt, Bohren der Löcher, mechanische Vorbehandlung und gegebenenfalls chemischer Aufschluß).
2. Die fotochemische Bildübertragung auf das Basismaterial (d.h. Aufbringen des Aktivators, Belichten durch eine Fotomaske und Keimstabilisierung).
3. Der Leiteraufbau durch chemische Metallisierung (d.h. Vormetallisierung, Dickverkupferung und gegebenenfalls Oberflächenschutz).

Aus der Literatur sind eine Reihe von Verfahren bekannt, wie man die Lichtempfindlichkeit von chemischen Verbindungen oder chemischen Reaktionen für eine fotoselektive Metallisierung ausnutzen kann. Eine Reihe dieser Verfahren wird beispielsweise in Galvanotechnik 74 (1983), Seite 1523, beschrieben. Keines dieser Verfahren hat sich bisher gegenüber der Subtraktivtechnik durchsetzen können.

Das gilt auch für die Verfahren zur lichtinduzierten Metallabscheidung gemäß US-A-3 904 783 und Review of the Electrical Communication Laboratories, Band 25, Nr. 5 - 6, Seiten 570 - 579, bei denen die Lichtempfindlichkeit von Silberverbindungen aus Glutaminsäure, Glykolsäure, Oxalsäure und Salicylsäure für die partielle stromlose Metallisierung genutzt wird.

Gegenstand der Erfindung ist demgegenüber ein Verfahren zum Aktivieren von Substratoberflächen für deren stromlose partielle Metallisierung, wobei man die Oberflächen mit einer Lösung oder Anreibung von im festen Zustand lichtempfindlichen Silber-I-Salzen organischer Säuren benetzt, das Lösungs- oder Anreibemittel entfernt, die auf den Oberflächen zurückbleibenden Silber-I-Salze partiell belichtet, gegebenenfalls den Belichtungseffekt durch Wärmeeinwirkung und/oder Behandlung mit einem fotografischen Entwickler verstärkt und/oder das bei der Belichtung entstandene Silber gegen edlere Metalle austauscht und die nicht belichteten Silber-I-Salze von den Substratoberflächen ablöst, dadurch gekennzeichnet, daß man Salze der Milchsäure oder Citronensäure verwendet.

Die lichtempfindlichen Silber-I-Salze können auch als Gemische eingesetzt werden. Zur Erhöhung der Lichtempfindlichkeit können den erfindungsgemäßen Lösungen auch Fremdionen wie beispielsweise $Cu^{2+}$, $Au^{3+}$ zugesetzt werden, deren Einbau zur Bildung von Kristallfehlstellen in den festen Silber-I-Salzen führen kann.

Im übrigen ist es nicht unbedingt erforderlich, die erfindungsgemäßen lichtempfindlichen Salze als definierte Reinsubstanzen einzusetzen. Da in den erfindungsgemäß bevorzugten Lösungen dissoziierte Ionen vorliegen dürften, ist es auch möglich, Salzgemische einzusetzen, aus denen dann beim Entfernen des Lösungsmittels die lichtempfindlichen Salze entstehen.

Eine Erhöhung der Lichtempfindlichkeit der Silber-I-Salze kann auch durch Zugabe von Sensibilisatoren erreicht werden. Derartige Sensibilisatoren sind in der Fotografie und Fotochemie bekannt. Konstitution und Konzentration derartiger Verbindungen werden beispielsweise in "Ullmann's Enzyclopädie der technischen Chemie", 4. Auflage, Bd. 18, S. 430 bis 434 beschrieben. Ganz besonders geeignet sind Sensibilisatoren, deren Absorptionsmaximum im UV liegt.

Die Konzentration der erfindungsgemäß einzusetzenden Lösungen oder Anreibungen der Silber-I-Salze sollte 0,5 g bis 75 g, vorzugsweise 5 bis 30 g Ag pro Liter betragen.

Als Lösungsmittel kommen insbesondere Wasser, DMF, DMSO, Dimethylacetamid, aliphatische Alkohole, auch Di- und Polyole, wie z. B. Ethylenglykole oder Glyzerin in Betracht. Es können auch Mischungen derartiger Lösungsmittel oder Verschnitte mit anderen organischen Lösungsmitteln eingesetzt werden.

Die erfindungsgemäßen Lösungen oder Anreibungen können auch Zusätze zur Verbesserung ihrer Eigenschaften enthalten. Aus Beispiele seien filmbildende Substanzen, wie Polyvinylalkohole und oberflächenaktive Verbindungen, sowie viskositätserniedrigende Substanzen genannt.

Vorzugsweise sind die Lösungen bzw. Anreibungen aber frei von diesen Substanzen, insbesondere frei von filmbildenden und anderen polymeren Stoffen.

Für die erfindungsgemäß zu verwendenden Silber-I-Salze, die bekanntlich in den erfindungsgemäß bevorzugten Lösungsmitteln schwer löslich sind, besteht eine bevorzugte Verfahrensvariante darin, diese mit Hilfe von Komplexbildnern in eine lösliche Form zu überführen, mit deren Lösungsmittel die zu metallisierenden Oberflächen zu benetzen und anschließend die an den Oberflächen zurückbleibenden löslichen Komplexverbindungen in die schwer löslichen Verbindungen zurückzuspalten.

Für diese verfahrensvariante besonders geeignete Komplexbildner zum Lösen der schwer löslichen Silberverbindungen sind stickstoffhaltige Verbindungen, die durch Einwirkung von Wärme und/oder Säuren leicht spaltbare Komplexe liefern. Besonders bevorzugt in wäßriger Lösung ist Ammoniak, darüber hinaus können auch Amine eingesetzt werden, deren Siedepunkt sollte aber bevorzugt unter 100°C liegen. Grundsätzlich sind auch andere Komplexbildner einsetzbar, wie z. B. Cyanidionen.

Die Rückspaltung der auf den Substratoberflächen zurückbleibenden Komplexverbindungen geschieht durch Wärmeeinwirkung, wobei Temperatur- und Trockenbedingungen so gewählt werden müssen, daß die Oberflächen der Substrate nicht angegriffen werden. Im allgemeinen werden dabei Temperaturen von 0°C bis 200°C, vorzugsweise 50°C bis 150°C angewandt; in besonderen Fällen (Gefriertrocknung, Einbrennen) können diese Temperaturen auch unteroder überschritten werden.

Es ist aber auch möglich, auf den befeuchteten Oberflächen durch eine chemische Reaktion die schwer löslichen Silbersalze auszufällen.

Es ist aber auch möglich, auf den befeuchteten Oberflächen durch eine chemische Reaktion die schwer löslichen Silbersalze auszufällen. Als Beispiel sei das Ansäuern einer Silberaminchloridlösung mit Mineralsäuren genannt, das zum Ausfällen von Silberchlorid führt. In diesen Fällen ist auch die Entfernung des Komplexbildners nicht mehr erforderlich.

Die partiell zu metallisierenden Oberflächen werden mit den erfindungsgemäßen Lösungen oder Anreibungen benetzt. Dabei kann die Benetzung beispielsweise durch Eintauchen der Oberfläche oder durch Aufsprühen oder Aufstreichen der Lösungen erfolgen. Vor der Benetzung kann es erforderlich sein, durch eine Vorbehandlung die Benetzbarkeit der Substratoberflächen und/oder die Haftfestigkeit der später abgeschiedenen Metallschicht zu verbessern. Als Beispiel hierfür sei die Chromschwefelsäurebeize von ABS-Kunststoffen bzw. von glasfaserverstärkten Epoxidharzen mit Haftvermittlerschichten genannt.

Weiterhin ist es auch möglich, die Lösungen durch Stempeln, durch Druckverfahren oder ink jet-Verfahren aufzubringen.

Die Benetzung wird bei Temperaturen zwischen 0°C und 90°C durchgeführt. In besonderen Fällen kann die Temperatur auch darunter oder darüber liegen. Ganz besonders bevorzugt wird bei 15°C bis 40°C gearbeitet.

Nach der Benetzung werden die Lösungs- bzw. Anreibungsmittel entfernt. Bevorzugt geschieht dies durch Wärmeeinwirkung, wobei Temperatur und Trockenbedingungen so gewählt werden müssen, daß die Oberflächen der Substrate nicht angegriffen werden. Im allgemeinen werden dabei Temperaturen von 0°C bis 200°C, vorzugsweise 50 bis 150°C angewandt; in besonderen Fällen (Gefriertrocknung, Einbrennen) können diese Temperaturen auch unter- oder überschritten werden.

Selbstverständlich ist es bei der bevorzugten Variante, die darin besteht, schwer lösliche Silber-I-Salze durch Komplexbildung in eine lösliche Form zu überführen, erforderlich, den Komplexbildner anschließend wie bereits beschrieben zu entfernen.

Nach diesem Verfahrensschritt bleiben auf den Substratoberflächen feste, lichtempfindliche Silber-I-Salze zurück.

Die so aktivierten lichtempfindlichen Substratoberflächen werden anschließend partiell belichtet. Dafür kommen insbesondere als Lichtquellen in Betracht: sichtbares Licht (bei geeigneter Sensibilisierung), UV-Licht, Röntgen- und Elektronenstrahlen. Besonders bevorzugt wird eine Belichtung im UV-Bereich.

Die Belichtungsdauer hängt von der Strahlungsintensität und der Wellenlänge der verwendeten Lichtquelle ab. Sie kann von Sekunden bis zu 1 Stunde betragen. Bei Verwendung von sehr energiereicher Strahlung (Laser) kann die Belichtungszeit auch darunter liegen.

Die Belichtung kann auch in Gegenwart von Wärme durchgeführt werden, die bekannterweise zu einer Beschleunigung der fotochemischen Reduktion von Silbersalzen führen kann.

Im allgemeinen erfolgt die partielle Belichtung unter Verwendung einer geeigneten Maske.

Auch andere partielle Belichtungsverfahren können angewendet werden, z. B. indem man mit einer fein gebündelten Lichtquelle die Leiterbahnen auf den Oberflächen "aufzeichnet", gegebenenfalls Computer-gesteuert.

Der Effekt der partiellen Belichtung kann gegebenenfalls durch einen weiteren Verfahrensschritt verstärkt werden. Geeignete Verfahren sind unter dem Begriff "Entwicklung" aus der Fotographie bekannt. Hierfür können die in der Fotografie üblichen Entwickler verwendet werden. Hinsichtlich ihrer chemischen Konstitution sei auf die Zusammenfassung in "Ullmann's Enzyclopädie der technischen Chemie", 4. Auflage, Bd. 18, Seiten 399 - 500, verwiesen. Geeignete Formulierungen sind im Handel (z. B. Handelsname "Neutrol" der Fa. Agfa, Leverkusen) erhältlich. Selbstverständlich können für eine derartige Entwicklung auch andere Redoxsysteme eingesetzt werden, deren Redoxpotential so eingestellt werden kann, daß nur die belichteten Silberkeime reduziert werden. Als Beispiele seien Formalinlösungen und Hypophosphitlösungen genannt, deren Redoxpotential sich über den pH-Wert einstellen läßt.

Eine Verstärkung des Belichtungseffekts kann auch durch eine Wärmebehandlung gegebenenfalls in Gegenwart von Ammoniakdämpfen erfolgen.

Die so partiell belichteten Substratoberflächen können anschließend einer Austauschreaktion unterworfen werden, durch die bei der Belichtung entstandenes Silber gegen edlere Metalle ausgetauscht wird. Darunter sind Metalle zu verstehen, deren Oxidationspotentiale in wässriger Lösung unter Standardbedingungen gemessen gegen die Normal-Wasserstoffelektrode positiver (bzw. gemäß US-Norm negativer) sind als das des Silbers.

Besonders bevorzugt werden Metalle wie Gold, Platin oder vorzugsweise Palladium eingesetzt, die darüber hinaus eine hohe katalytische Wirkung bei der stromlosen (chemischen) Metallisierung zeigen. Es können auch Gemische der Edelmetalle eingesetzt werden.

Bevorzugt wird die ße Austauschreaktion durch Behandeln der partiell belichteten Substratoberflächen mit einer Lösung dieser Edelmetalle durchgeführt. Zur Herstellung dieser Lösungen können Salze, Komplexverbindungen und/oder organometallische Verbindungen der Edelmetalle eingesetzt werden.

Als Lösungsmittel kommen insbesondere Wasser, DMF, DMSO, Dimethylacetamid, aliphatische Alkohole, auch Di- und Polyole, wie z. B. Ethylenglykole oder Glyzerin sowie für organometallische Verbindungen auch organische Lösungsmittel wie z. B. chlorierte Aliphaten, aliphatische Ester oder -Ketone, in Betracht. Es können auch Mischungen derartiger Lösungesmittel oder Verschnitte mit anderen Lösungsmitteln eingesetzt werden.

Besonders bevorzugt wird ein Verfahren, bei dem der Austausch in einer sauren, vorwiegend wässrigen Lösung von Edelmetallsalzen durchgeführt wird.

Die Konzentration an Edelmetallen in den Austauschlösungen liegt zwischen 0,05 g und 10 g pro Liter. Bevorzugt werden Lösungen, die zwischen 0,1 g und 2 g Edelmetall pro Liter enthalten.

Die Austauschreaktion wird bei Temperaturen zwischen 0°C und 90°C durchgeführt. In besonderen Fällen kann die Temperatur auch darunter oder darüber liegen. Ganz besonders bevorzugt wird bei 15°C bis 40°C gearbeitet.

Die Reaktionszeit beträgt zwischen 10 Sekunden und 30 Minuten. In besonderen Fällen können die Zeiten auch darunter oder darüber liegen. Bevorzugt werden Verweilzeiten zwischen 1 Minute und 10 Minuten.

Der bevorzugte Austausch des Silbers gegen edlere Metalle hat eine Reihe von Vorteilen. Die höhere katalytische Wirksamkeit der edleren Metalle hat zur Folge, daß eine geringere Anzahl an katalytisch wirksamen Keimen für eine einwandfreie partielle Metallisierung erforderlich ist. Daher können sowohl die Belichtungszeiten als auch die Konzentration an lichtempfindlichen Silbersalzen pro partiell zu belichtender Flächeneinheit reduziert werden. Darüber hinaus können zur Metallisierung der Oberflächen stabilere stromlose Bäder eingesetzt werden, die spontane Metallabscheidungen und Wildwuchs verhindern. Dadurch kann die Abbildungsgenauigkeit des Verfahrens erhöht werden, was insbesondere für die Feinstleitertechnik von großem Interesse ist.

Nach der Austauschreaktion ist ein Spülvorgang zum Entfernen der nicht umgesetzten Edelmetalle erforderlich.

Von den partiell belichteten und gegebenenfalls einer Austauschreaktion unterworfenen Oberflächen werden die nicht belichteten Silber-I-Salze anschließend wieder abgelöst. Geeignete Verfahren sind unter dem Begriff "Fixierung" aus der Fotografie bekannt. Dabei hat es sich als besonders günstig erwiesen, wenn man zur Ablösung der unbelichteten Silbersalze schwefelfreie Lösungen verwendet. Unter schwefelfrei im Sinne der Erfindung wird dabei verstanden, daß die Fixierlösung kein sulfidisches Schwefel bzw. keine Schwefelverbindungen enthält, aus denen durch Reaktion mit Silber Schwefel abgespalten wird.

Für das erfindungsgemäß neue Verfahren kommen besonders Fixierlösungen in Betracht, die Ammoniak, Ammoniumsalze, Amine oder Aminosäuren und deren Gemische enthalten. Ganz bevorzugt werden wäßrige Lösungen eingesetzt. Außerdem können auch Verschnitte von Wasser mit organischen Lösungsmitteln oder alkoholische Lösungen verwendet werden.

Die Konzentration an Silbersalz-ablösenden Substanzen beträgt im allgemeinen zwischen 1 und 500 g pro Liter.

Bevorzugt werden zwischen 5 und 200 g pro Liter eingesetzt. Die Verweilzeit in der Fixierlösung richtet sich nach der Konzentration und Wirksamkeit der das nicht belichtete Silber ablösenden Substanzen. Sie beträgt im allgemeinen zwischen 1 Sekunde und 15 Minuten. Bevorzugt werden Zeiten zwischen 10 Sekunden und 10 Minuten.

Die Temperatur bei der Fixierung liegt zwischen 0°C und 90°C. Bevorzugt wird das nicht belichtete Silber bei Temperaturen zwischen 15°C und 60°C abgelöst.

Ein Bewegen der Fixierlösung oder der Substratoberflächen in den Lösungen ist von Vorteil.

Es ist auch möglich, die partiell belichteten Oberflächen zuerst zu fixieren und erst anschließend die Austauschreaktion durchzuführen.

Aus den Fixierlösungen sowie den Austauschlösungen kann der größte Teil des eingesetzten Silbers wieder zurückgewonnen werden. Geeignete Verfahren sind aus der Fotografie bekannt.

Die so partiell aktivierten Substratoberflächen können anschließend stromlos metallisiert werden. Stromlose Metallisierungsbäder sind aus der Galvanotechnik hinlänglich bekannt. Bevorzugt kommen Bäder mit Nickelsalzen, Kobaltsalzen, Kupfersalzen oder deren Gemische mit Eisensalzen, Gold- und Silbersalzen in Betracht.

Gegebenenfalls können die partiell stromlos metallisierten Oberflächen anschließend galvanisch verstärkt werden.

Als Substrate für das erfindungsgemäße Verfahren eignen sich Glas, Quarz, Keramik, Kohlenstoff, Papier, Polyethylen, Polypropylen, ABS-Kunststoffe, Epoxiharze, Polyester, Polycarbonate, Polyamide, Polyethylenfluorid und textile Flächengebilde aus Polyamid, Polyester, Polyalkylen, Polyacrylnitril, Polyvinylhalogenide, Baumwolle und Wolle sowie deren Mischungen oder Mischpolymerisate sowie Aluminiumoxid. Besonders bevorzugt sind Substrate, wie sie in der Leiterplattenfertigung eingesetzt werden, z. B. Phenolharzpapiere, Glasfaser-verstärkte Epoxidplatten und Keramik, die gegebenenfalls zur Verbesserung der Haftung der Aktivierungskeime an der Oberfläche durch eine geeignete Vorbehandlung "aufgerauht" werden müssen.

**Beispiel 1**

Eine Platte aus ABS-Kunststoff der Größe 5 x 5 cm wird 10 Minuten bei 65°C mit Chromsäure gebeizt, entgiftet und anschließend in eine ammoniakalisch wäßrige Lösung getaucht, die pro Liter 51 g Silbernitrat und 21 g Citronensäure enthält, und bei 50°C getrocknet. Anschließend wird mit Hilfe einer Quarzglasplatte eine Fotomaske direkt auf der Plattenoberfläche befestigt und die ABS-Platte durch die Maske aus 10 cm Abstand mit einer 250 Watt Quecksilberlampe 15 Minuten belichtet. Nach der Belichtung ist das Leiterbahnbild der Fotomaske deutlich auf der Plattenoberfläche zu erkennen. Anschließend wird die belichtete Platte 5 Minuten in einer 30-%-igen Ammoniumnitratlösung gewässert, die mit Ammoniak auf pH 9,3 eingestellt wurde, gespült und dann 20 Minuten in einer 0,1-%-igen wäßrigen Natriumborhydrid-Lösung reduziert. Nach 1stündiger Verkupferung in einem stromlosen Formalin-haltigen Kupferbad bei 60°C wird eine ABS-Platte mit klar erkennbaren, verkupferten Leiterbahnen erhalten.

**Beispiel 2**

Eine Glasfaser-gefüllte Epoxidharzplatte (FR 4) der Größe 10 x 5 cm, die beidseitig mit einer Haftvermittlerschicht beschichtet worden war, wird 2 Minuten bei 65°C in Chromsäure gebeizt, entgiftet und anschließend mit einer ammoniakalisch wäßrigen Lösung von 30 g/l Silber-l-Citrat durch Aufrollen benetzt.

Die FR 4-Platte wird anschließend getrocknet und dann mittels einer Quecksilberlampe gemäß Beispiel 2 durch eine Fotomaske 10 Minuten belichtet. Nach der Belichtung ist die Abbildung des Leiterbahnbildes der Fotomaske deutlich auf der Plattenoberfläche zu erkennen. Anschließend wird die belichtete Platte 10 Minuten in einer 10-%-igen wäßrigen Ammoniaklösung gewässert, gespült und dann direkt 1 Stunde in einem stromlosen Formalin-haltigen Kupferbad bei 60°C verkupfert. Man erhält eine FR 4-Platte mit deutlich erkennbaren, voneinander getrennten verkupferten Leiterbahnen.

**Beispiel 3**

Eine Platte aus ABS-Kunststoff (Acrylnitril /Butadien/Styrol-Terpolymeren) der Größe 10 x 12 cm wird 10 Minuten bei 65°C mit Chromsäure gebeizt, entgiftet und anschließend in eine ammoniakalisch-wäßrige Lösung getaucht, die pro Liter 35 g Silbernitrat und 40 g Citronensäure enthält und bei 50°C getrocknet. Anschließend wird mit Hilfe einer Quarzglasplatte eine Fotomaske direkt aus der Plattenoberfläche befestigt und die ABS-Platte durch die Maske aus 12 cm Abstand mit einer 250 Watt Quecksilberlampe 15 Minuten belichtet. Nach der Belichtung ist das Leiterbahnbild der Fotomaske deutlich auf der Plattenoberfläche zu erkennen. Anschließend wird die belichtete Platte 1 Minute in eine 0,1-%-ige salzsaure Palladium(II)-chloridlösung getaucht, dann 30 Sekunden mit destilliertem Wasser gespült und danach 5 Minuten in einer 40-%-igen Ammoniumnitratlösung gewässert, die mit Ammoniak auf pH 9,0 eingestellt wurde. Nach sorgfältigem Spülen mit Wasser wird die Platte 1 Stunde in einem Aminboran-haltigen Nickelbad metallisiert. Man erhält eine ABS-Platte mit deutlich erkennbaren, voneinander getrennten vernickelten Leiterbahnen.

**Beispiel 4**

Eine Glasfaser-gefüllte Epoxidharzplatte (FR 4) der Größe 10 x 20 cm, die beidseitig mit einer Haftvermittlerschicht beschichtet worden war, wird mit einer ammoniakalisch-wässrigen Lösung von 40 g Silber-lcitrat, deren Viskosität durch 2-%-ige Zugabe einer Polyacrylsäure erhöht wurde, durch Aufrollen benetzt. Die FR 4-Platte wird anschließend getrocknet und dann mittels einer Quecksilberlampe gemäß Beispiel 1 durch eine Fotomaske 10 Minuten belichtet. Nach der Belichtung ist die Abbildung des Leiterbahnbildes der Fotomaske deutlich auf der Plattenoberfläche zu erkennen. Anschließend wird die belichtete Platte 10 Minuten in eine salzsaure Lösung getaucht, die 0,5 g $AuCl_3$ pro Liter enthält, und anschließend gespült. Danach wird die belichtete Platte 10 Minuten in einer 10-%-igen wäßrigen Ammoniaklösung gewässert, gespült und dann direkt eine Stunde in einem stromlosen Formalin-haltigen Kupferbad bei 60°C verkupfert. Man erhält eine FR 4-Platte mit deutlich erkennbaren, von einander getrennten verkupferten Leiterbahnen.

**Beispiel 5**

Eine Glasfaser-gefüllte Epoxidharzplatte wird 10 Minuten bei 65°C mit Chromsäure gebeizt, entgiftet, mit einer ammoniakalischen Lösung von 25 g Silbernitrat und 40 g Milchsäure in Wasser/Ethanol (9 : 1) durch Eintauchen benetzt und anschließend getrocknet. Dann wird mit einer Quecksilberlampe gemäß Beispiel 1 durch eine Fotomaske 15 Minuten belichtet. Nach der Belichtung ist die Abbildung des Leiterbahnbildes der Fotomaske deutlich auf der Plattenoberfläche zu erkennen. Anschließend wird die belichtete Platte 2 Minuten mit einer salzsauren Lösung von 2 g $PdCl_2$ pro Liter Wasser besprüht.

Anschließend wird die Platte gespült, in einer 10-%-igen Aminoessigsäurelösung, die mit Ammoniak auf pH 9 eingestellt wurde, bei 45°C gewässert, gespült und dann in einem stromlosen Formalin-haltigen Kupferbad bei 40°C 3 Stunden verkupfert. Man erhält eine FR 4-Platte mit deutlich erkennbaren, voneinander getrennte verkupferten Leiterbahnen.

## Patentansprüche

1. Verfahren zum Aktivieren von Substratoberflächen für deren stromlose partielle Metallisierung, wobei man die Oberflächen mit einer Lösung oder Anreibung von im festen Zustand lichtempfindlichen Silber-I-Salzen organischer Säuren benetzt, das Lösungs- oder Anreibemittel entfernt, die auf den Oberflächen zurückbleibenden Silber-I-Salze partiell belichtet, gegebenenfalls den Belichtungseffekt durch Wärmeeinwirkung und/oder Behandlung mit einem fotografischen Entwickler verstärkt und/oder das bei der Belichtung entstandene Silber gegen edlere Metalle austauscht und die nicht belichteten Silber-I-Salze von den Substratoberflächen ablöst, dadurch gekennzeichnet, daß man Salze der Milchsäure oder Citronensäure verwendet.

2. Verfahren nach Anspruch 1, dadurch gekennzeichnet, daß man die Silber-I-Salze, die in den zu verwendenden Lösungsmitteln schwer löslich sind, mit Hilfe von Komplexbildnern in eine lösliche Form überführt, mit deren Lösung die partiell zu metallisierenden Oberflächen benetzt und anschließend die an den Oberflächen zurückbleibenden Komplexverbindungen in die lichtempfindlichen schwer löslichen Verbindungen zurückspaltet.

3. Verfahren nach Anspruch 1 und 2, dadurch gekennzeichnet, daß man als lichtempfindliches Silber-I-Salz das Salz der Milchsäure verwendet.

4. Verfahren nach Anspruch 2, dadurch gekennzeichnet, daß als Komplexbildner Ammoniak oder Amine mit einem Siedepunkt unter 100°C eingesetzt werden.

5. Verfahren nach Anspruch 1, dadurch gekennzeichnet, daß die Konzentration an Silber-I-Verbindungen in den Anreibungen bzw. Lösungen 0,05 bis 7,5 % betragen.

6. Verfahren nach Anspruch 1, dadurch gekennzeichnet, daß man Aktivierungslösungen verwendet, die frei von filmbildenden und anderen polymeren Substanzen sind.

7. Verfahren nach Anspruch 1, dadurch gekennzeichnet, daß man zur Ablösung der nicht belichteten Silber-I-Verbindungen von der Oberfläche schwefelfreie Fixierlösungen verwendet.

8. Verfahren nach Anspruch 1, dadurch gekennzeichnet, daß man als edlere Metalle Gold, Platin oder Palladium verwendet.

9. Verfahren nach Anspruch 1, dadurch gekennzeichnet, daß die Austauschreaktion durch Behandeln mit einer Lösung von Salzen, Komplexverbindungen und/oder organometallischen Verbindungen der Edelmetalle durchgeführt wird.

10. Verwendung des Verfahrens gemäß Anspruch 1-9 zur Herstellung von gedruckten Schaltungen.

## Claims

1. Process for the activation of substrate surfaces for the purpose of electrolessly partially metallising them, in which the surfaces are wetted with a solution or a coating paste of silver(I) salts of organic acids which are photosensitive in the solid state, the solution or pasting agent is removed, the silver(I) salts left behind on the surfaces are partially exposed, if necessary, the effect of the exposure is intensified by the action of heat and/or treatment with a photographic developer and/or the silver produced during the exposure is exchanged for nobler metals and the unexposed silver(I) salts are detached from the substrate surfaces, characterized in that the salts of lactic acid or citric acid are used.

2. Process according to Claim 1, characterised in that the silver(I) salts which are sparingly soluble in the solvents to be used are converted into a soluble form by means of complexing agents, the surfaces to be partially metallised are wetted with the solution of the latter and subsequently the complex compounds left behind on the surfaces are split up again into the photosensitive sparingly soluble compounds.

3. Process according to Claim 1 and 2, characterised in that the salt of lactic acid is used as photosensitive silver(I) salt.

4. Process according to Claim 2, characterised in that ammonia or amines with a boiling point below 100°C are used as complexing agents.

5. Process according to Claim 1, characterised in that the concentration of silver(1) compounds in the coating pastes or solutions is 0.05 to 7.5 %.

6. Process according to Claim 1, characterised in that activation solutions are used which are free from film-forming and other polymeric substances.

7. Process according to claim 1, characterised in that sulphur-free fixing solutions are used to detach the unexposed silver(1) compounds from the surface.

8. Process according to claim 1, characterised in that gold, platinum or palladium are used as nobler metals.

9. Process according to claim 1, characterised in that the exchange reaction is carried out by treating with a solution of salts, complexing agents and/or organometallic compounds of the noble metals.

10. Use of the process according to claim 1-9 for the manufacture of printed circuits.

## Revendications

1. Procédé d'activation de surfaces de substrats pour leur métallisation partielle sans courant, dans lequel on humidifie les surfaces avec une solution ou une pâte de trituration de sels d'argent I d'acides organiques, photosensibles à l'état solide, on enlève le solvant ou la pâte, on expose partiellement les sels d'argent I restants sur les surfaces, on renforce éventuellement l'effet d'exposition par l'action de la chaleur et/ou par traitement avec un révélateur photographique et/ou on échange contre des métaux nobles l'argent apparaissant lors de l'exposition et on enlève par dissolution les sels d'agent I non exposés des surfaces du substrat, caractérisé en ce qu'on utilise des sels d'acide lactique ou d'acide citrique.

2. Procédé suivant la revendication 1, caractérisé en ce que les sels d'argent I qui sont difficilement solubles dans les solvants à utiliser sont solubilisés à l'aide d'agents complexants, les surfaces devant être partiellement métallisées sont mouillées avec leur solution puis les complexes restant sur les surfaces sont rétrogradés en les composés photosensibles difficilement solubles.

3. Procédé suivant les revendications 1 et 2, caractérisé en ce qu'on utilise comme sel d'argent I photosensible le sel de l'acide lactique.

4. Procédé suivant la revendication 2, caractérisé en ce qu'on utilise comme complexant l'ammoniac ou des amines ayant un point d'ébullition inférieur à 100°C.

5. Procédé suivant la revendication 1, caractérisé en ce que la concentration en composés d'argent I dans les pâtes ou les solutions est de 0,05 à 7,5 %.

6. Procédé suivant la revendication 1, caractérisé en ce qu'on utilise des solutions d'activation qui sont dépourvues de substances polymériques filmogènes et autres.

7. Procédé suivant la revendication 1, caractérisé en ce qu'on utilise des solutions de fixage dépourvues de soufre pour détacher de la surface les composés d'argent I non exposés.

8. Procédé suivant la revendication 1, caractérisé en ce qu'on utilise comme métaux plus nobles l'or, le platine ou le palladium.

9. Procédé suivant la revendication 1, caractérisé en ce que la réaction d'échange est effectuée par traitement avec une solution de sels, de composés complexes et/ou de composés organométalliques des métaux nobles.

10. Utilisation du procédé suivant les revendications 1 à 9 pour la réalisation de circuits imprimés.